# DEMANDE DE BREVET EUROPEEN

(11) **EP 4 658 032 A1**
(43) Date de publication de la demande: **03.12.2025**
(21) Numéro de dépôt: 25177679.5
(22) Date de dépôt: 20.05.2025
(51) Int. Cl.: H10H 20/816, H10H 20/818, H10H 20/819, H10H 20/821, H10H 20/01, H10H 20/812, H10H 20/813, H10H 20/825, H10H 20/831, H10H 20/84

(54) **DIODE ÉLECTROLUMINESCENTE 3D ET SON PROCÉDÉ DE FABRICATION**

(30) Priorité: 30.05.2024 FR 2405602
(71) Demandeur: Aledia, 38800 Champagnier (FR)
(72) Inventeur: Pourquier, Eric, 34430 Saint Jean de Vedas (FR)
(74) Mandataire: Hautier IP

(57) **Abrégé**

L'invention concerne une diode électroluminescente (1) et son procédé de fabrication. La diode électroluminescente (1) comprend au moins une structure tridimensionnelle 3D (20) radiale comprenant: un cœur (21) présentant une première conductivité, et présentant une forme de fil ou de pyramide orienté(e) selon une direction z avec des flancs (210) sensiblement parallèles ou obliques à la direction z, une région active (22) configurée pour émettre un rayonnement lumineux, la région active (22) comprenant au moins une partie radiale (220) couvrant les flancs (210) du cœur (21), et une coquille (23) présentant une deuxième conductivité. La diode (1) comprend, en outre, une couche (33) magnétique présentant une polarisation (M) selon une direction principale sensiblement parallèle à la direction z, de façon à augmenter le temps de résidence au niveau de la région active (22) d'au moins l'un parmi le premier type et le deuxième type de porteurs.

## Description

### DOMAINE TECHNIQUE

La présente invention concerne le domaine de l'optoélectronique. Elle trouve pour application particulièrement avantageuse la fabrication de dispositifs optoélectroniques présentant une structure tridimensionnelle (3D), par exemple des diodes électroluminescentes à base de nanofils.

### ETAT DE LA TECHNIQUE

Une diode électroluminescente (LED) comprend typiquement des régions d'injection de porteurs (électrons et trous) entre lesquelles est intercalée une région active. La région active est le lieu où se produisent des recombinaisons radiatives de paires électron-trou, qui permettent d'obtenir une émission de lumière. Cette région active peut notamment comprendre des puits quantiques, par exemple à base d'InGaN.

Les LED présentant une structure tridimensionnelle (LED 3D), typiquement sous forme de nanofils ou de pyramides, peuvent présenter différentes architectures, notamment au niveau de l'agencement des différentes régions constitutives de la LED.

Ces différentes régions peuvent être disposées radialement autour de la direction longitudinale z. Une telle architecture de LED est dite radiale ou cœur-coquille. Une LED 3D radiale présente typiquement une partie interne (le cœur) allongée selon z et prenant appui sur un substrat, une région active entourant la partie interne, et une partie externe (la coquille) entourant la région active. La partie interne est généralement destinée à l'injection d'électrons et la partie externe à l'injection de trous. La région active présente typiquement des puits quantiques s'étendant de façon parallèle à la direction longitudinale z dans le cas de LED 3D radiales de type nanofil, ou oblique dans le cas de LED 3D radiales pyramidales.

Pour améliorer le taux de recombinaisons radiatives, c'est-à-dire l'efficacité quantique externe (EQE) des LED 3D, une solution existante consiste à confiner les porteurs au sein de la région active en ajoutant une ou plusieurs couches de blocage de porteurs autour de la région active. En particulier, une couche de blocage d'électrons (EBL, abrégé de l'anglais Electron Blocking Layer) peut être ajoutée entre la région d'injection de trous et la région active. Cette couche EBL évite que les électrons issus de la région d'injection d'électrons traversent la région active sans se recombiner. La couche EBL est configurée pour bloquer les électrons et laisser passer les trous.

En pratique, l'introduction de ces couches EBL engendre d'autres problèmes, notamment l'apparition de défauts structuraux, l'apparition de résistances électriques en série et/ou un ralentissement indésirable des porteurs qui doivent passer au travers de ces couches. D'un point de vue technologique, la formation des couches EBL dans des architectures de LED 3D n'est pas suffisamment maîtrisée.

Il existe donc un besoin pour concevoir une architecture de LED 3D radiale présentant une EQE améliorée. La présente invention vise à répondre à ce besoin et/ou à pallier au moins partiellement les inconvénients mentionnés ci-dessus.

En particulier, un objet de la présente invention est de proposer une diode électroluminescente à structure 3D radiale, de type nanofil ou pyramidale, présentant une EQE optimisée. Un autre objet de la présente invention est de proposer un procédé de fabrication d'une telle diode électroluminescente.

Les autres objets, caractéristiques et avantages de la présente invention apparaîtront à l'examen de la description suivante et des dessins d'accompagnement. Il est entendu que d'autres avantages peuvent être incorporés. En particulier, certaines caractéristiques et certains avantages du dispositif peuvent s'appliquer *mutatis mutandis* au procédé, et réciproquement.

### RESUME

Pour atteindre cet objectif, selon un premier aspect on prévoit une diode électroluminescente comprenant au moins une structure tridimensionnelle 3D radiale comprenant :
- un cœur présentant une première conductivité d'un premier type de porteurs, le cœur présentant une forme de fil ou de pyramide orientés selon une direction z, et présentant des flancs sensiblement parallèles ou obliques à la direction z,
- une région active configurée pour émettre un rayonnement lumineux de longueur d'onde λ, la région active comprenant au moins une partie dite radiale couvrant les flancs du cœur,
- une coquille présentant une deuxième conductivité d'un deuxième type de porteurs, la coquille couvrant au moins la partie radiale de la région active,

Avantageusement, la diode comprend au moins une couche magnétique configurée pour présenter une polarisation selon une direction principale sensiblement parallèle à la direction z, de façon à augmenter le temps de résidence au niveau de la région active d'au moins l'un parmi le premier type et le deuxième type de porteurs.

Ainsi, la couche magnétique génère un champ magnétique sensiblement dans l'axe de la structure 3D filaire ou pyramidale. Au niveau de la région active, les composantes de vitesse perpendiculaires au champ magnétique des porteurs de charge, et notamment des électrons, sont importantes. Le champ magnétique généré perturbe ainsi la trajectoire des électrons, ce qui permet de maintenir plus longtemps des électrons dans la région active comprenant les puits quantiques. Le champ magnétique généré peut même provoquer un piégeage des porteurs de charge, et notamment des électrons, dans les non-uniformités des puits quantiques, typiquement riches en indium. On comprend donc que cette architecture permet d'améliorer l'EQE.

Le cœur de la structure 3D est typiquement à base ou fait de GaN-n. La coquille de la structure 3D est typiquement à base ou fait de GaN-p. La couche magnétique provoque typiquement une modification de la trajectoire des électrons se propageant dans le cœur en GaN-n de façon à maintenir leur temps de résidence dans la région active et d'augmenter les possibilités de recombinaisons radiatives.

Un autre aspect concerne un procédé de réalisation d'une diode électroluminescente comprenant au moins une structure tridimensionnelle 3D, selon le premier aspect, le procédé comprenant :
- former le cœur par épitaxie sur un substrat de croissance, par croissance localisée au travers d'une ouverture d'une couche de masquage disposée sur le substrat de croissance,
- former par épitaxie la région active sur le cœur,
- former par épitaxie la coquille sur la région active, puis
- déposer l'au moins une couche magnétique de sorte que ladite couche magnétique présente une polarisation selon une direction principale sensiblement parallèle à la direction z.

Les effets et avantages décrits ci-dessus s'appliquent au procédé selon cet aspect.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La figure 1 illustre une LED 3D radiale en forme de fil comprenant une couche magnétique, selon un exemple de réalisation de la présente invention.
La figure 2 illustre une LED 3D radiale en forme de fil comprenant une couche magnétique, selon un autre exemple de réalisation de la présente invention.
La figure 3 illustre une LED 3D radiale en forme de pyramide comprenant une couche magnétique, selon un exemple de réalisation de la présente invention.
Les figures 4A à 4C illustrent différents agencement de motifs de la couche magnétique avec plusieurs structures 3D, selon plusieurs exemples de réalisation.
Les figures 5 à 16A illustrent schématiquement différentes étapes d'un procédé de réalisation d'une LED 3D comprenant une couche magnétique, selon un exemple de réalisation de la présente invention.
Les figures 16B à 16D illustrent schématiquement deux variantes de réalisation de la couche magnétique sur le premier contact de la LED 3D, selon un exemple de réalisation de la présente invention.
Les figures 17A et 17B illustrent schématiquement une variante de réalisation de la couche magnétique sur le deuxième contact de la LED 3D, selon un exemple de réalisation de la présente invention.
Les figures 18A et 18B illustrent schématiquement une autre variante de réalisation de la couche magnétique sur le deuxième contact de la LED 3D, selon un exemple de réalisation de la présente invention.
La figure 19 illustre schématiquement une variante de réalisation de la couche magnétique, selon un exemple de réalisation de la présente invention.
Les figures 20 et 21 illustrent des résultats de simulation de champ magnétique généré pour une disposition relative des structures 3D et des motifs de la couche magnétique telle qu'illustrée en figure 4A, selon un exemple de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les dimensions des différentes couches et des différentes parties de la LED 3D ne sont pas forcément représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement.

Selon un exemple, les porteurs du premier type sont des électrons et la première conductivité est de type N, les porteurs du deuxième type sont des trous et la deuxième conductivité est de type P, l'au moins une couche magnétique étant configurée de façon à augmenter le temps de résidence au niveau de la région active des électrons s'étant propagés dans le cœur.

Selon un exemple, l'au moins une couche magnétique s'étend dans un plan d'extension principale sensiblement perpendiculaire à la direction z et comprend des motifs distribués selon un pas p le long d'au moins une direction de son plan d'extension principale, de façon à former une pluralité de portions dépourvues de matériau magnétique, et de préférence lesdits motifs sont distribués selon un premier réseau de pas p, le long de deux directions distinctes de son plan d'extension principale.

La couche magnétique présente ainsi une structuration selon un motif se répétant selon au moins une direction de son plan d'extension principale La couche magnétique est ainsi discontinue, selon une et de préférence deux directions de son plan d'extension principale. Ces deux directions sont alors de préférence perpendiculaires.

La discontinuité de la couche magnétique permet de générer des maximums locaux de champ magnétique. Cela induit des portions à forts champs induit. L'effet de perturbation de la trajectoire des porteurs de charge est ainsi amélioré dans le plan d'extension principale de la couche magnétique.

Selon un exemple, l'au moins une couche magnétique présente des rainures, lesdites rainures étant dépourvues de matériaux magnétiques ou la couche magnétique étant formée au moins en partie par lesdites rainures à base ou fait d'un matériau magnétique
Selon un exemple, l'au moins une couche magnétique présente une structuration en plot, lesdits plots étant dépourvus de matériaux magnétiques ou la couche magnétique étant formée au moins en partie par lesdits plots à base ou fait d'un matériau magnétique.

Selon un exemple, la diode comprend une pluralité de structures 3D, la pluralité de structures 3D étant distribuées selon le même pas p que les motifs de la couche magnétique.

La pluralité de structures 3D est ainsi disposée en coïncidence avec les motifs de la couche magnétique. Les structures 3D sont ainsi disposées en accord avec les maximums locaux de champs magnétique. Plus particulièrement, les structures 3D peuvent ainsi être placées dans les portions à forts champs induits, pour améliorer encore l'EQE. La pluralité de structures 3D peuvent être distribuées selon un deuxième réseau de même pas p que le premier réseau. Selon un exemple, l'au moins une couche magnétique présente une polarisation, de préférence une polarisation permanente, comprise entre 0,1 T et 1,5 T, de préférence sensiblement égale à 0,5 T.

Cette gamme de polarisation permet de générer des champs magnétiques d'intensité comprise entre 100 Gauss et 5000 Gauss. Lors du développement de l'invention, il a été mis en évidence que cette gamme était particulièrement adaptée pour perturber la trajectoire des porteurs de charge dans des structures 3D de LED. Ceci est particulièrement avantageux pour des structures 3D présentant une hauteur selon la direction z de l'ordre du µm, par exemple entre 0,1 µm et 5 µm.

Selon un exemple, l'au moins une couche magnétique est à base ou faite d'un matériau ferromagnétique.

Selon un exemple, l'au moins une couche magnétique est à base ou est faite d'un matériau comprenant au moins un élément choisi parmi le cobalt, le fer et le nickel.

Selon un exemple, l'au moins une couche magnétique est à base ou est faite d'un matériau choisi parmi le groupe constitué de CoFeB, CoFe, NiW, NiFe.

Selon un exemple, l'au moins une couche magnétique comprend un empilement de sous-couches, ledit empilement comprenant au moins une première sous-couche à base ou faite d'un matériau ferromagnétique, disposée entre deux deuxièmes sous-couches à base ou faites d'un matériau métallique amagnétique. Les propriétés magnétiques peuvent dépendre des épaisseurs des sous-couches. En particulier, des sous-couches fines, par exemple présentant une épaisseur de l'ordre de quelques nanomètres, peuvent avoir une polarisation permanente perpendiculaire au plan d'extension principale de la couche. En cumulant des sous-couches fines séparées par un matériau amagnétique il est possible de cumuler les polarisations des sous-couches magnétiques.

Selon un exemple, l'au moins une couche magnétique présente une épaisseur comprise entre 0,5 nm et 50 nm, de préférence entre 1 nm et 30 nm. Selon un exemple, la couche magnétique présente une épaisseur comprise entre 30 nm et 50 nm.

Selon un exemple :
- les flancs du cœur sont sensiblement parallèles à la direction z, et
- la partie radiale de la région active s'étend selon une direction d'extension principale sensiblement parallèle à la direction z.

Selon un exemple, la diode comprend en outre :
- un premier contact électriquement conducteur configuré pour injecter des porteurs du premier type dans le cœur,
- un deuxième contact électriquement conducteur configuré pour injecter des porteurs du deuxième type dans la coquille.

Selon un exemple, la couche magnétique est sous-jacente, selon la direction z, au premier contact. Selon un exemple alternatif ou combinable, la couche magnétique surmonte, selon la direction z, le deuxième contact, de préférence la couche magnétique présente un plan d'extension principale sensiblement parallèle à la couche de masquage.

Selon un exemple, la diode comprend en outre au moins une couche électriquement isolante intercalée entre la couche magnétique et le premier contact.

Selon un exemple, la diode comprend en outre au moins une couche électriquement isolante intercalée entre la couche magnétique et le deuxième contact.

Selon un exemple, la diode comprend en outre une couche de masquage présentant une face dite inférieure, une face dite supérieure, et des ouvertures, et le cœur traverse la couche de masquage au niveau desdites ouvertures.

Cette caractéristique structurelle de la LED 3D est typiquement liée à un procédé de croissance localisée SAG (acronyme de « Selective Area Growth ») des structures 3D. La présence de la couche de masquage est généralement un élément résiduel de la mise en œuvre d'une croissance localisée SAG. Une telle couche de masquage n'est pas présente dans des LED 2D dites planaires. Des LED structurées en mésa par gravure de couches planaires, selon une approche technologique désignée par les termes « top-down », ne présentent pas de couche de masquage. La couche de masquage est généralement spécifique à la mise en œuvre d'un procédé SAG pour la formation de structures 3D, selon une approche technologique désignée par les termes « bottom-up ». La présence de la couche de masquage est un moyen de différenciation entre des LED 3D « bottom-up » et des LED « top-down » issues de technologies planaires.

Selon un exemple, la structure tridimensionnelle est obtenue par croissance localisée au travers des ouvertures de la couche de masquage.

Les ouvertures de la couche de masquage peuvent être régulièrement distribuées sous forme d'un réseau. Une portion à la base du cœur de la structure 3D est typiquement enserrée par la couche de masquage. Le cœur peut en outre s'élargir au-dessus de la portion enserrée, et prendre appui sur la couche de masquage.

Selon un exemple, l'au moins une couche magnétique surmonte, selon la direction z, la couche de masquage.

Selon un exemple, la partie radiale forme au moins 80% de la région active.

Du fait des effets et avantages précédemment présentés, on comprend que l'EQE peut être améliorée sans nécessairement recourir à une EBL.

Selon un exemple, la LED 3D comprend en outre une couche de blocage du premier type de porteurs intercalée entre la coquille et la région active. Un effet synergique entre la perturbation de la trajectoire des porteurs dû à la couche magnétique d'une part, et le blocage des porteurs dû à la couche de blocage d'autre part, peut ainsi être obtenu.

Selon un exemple, le cœur et la coquille sont à base ou fait de GaN, et la région active comprend des puits quantiques à base ou fait d'InGaN.

Selon un exemple, la couche magnétique s'étend de façon transverse, et notamment perpendiculaire ou oblique, à ladite partie radiale. Selon un exemple, le plan d'extension principale de la couche magnétique est transverse, et notamment perpendiculaire ou oblique, à la direction d'extension principale de la partie radiale de la région active.

Selon un exemple, le procédé comprend en outre :
- déposer une couche de planarisation sur le substrat de croissance, sur et autour de l'au moins une structure 3D en saillie du substrat de croissance, de façon à obtenir une surface plane au-dessus de l'au moins une structure 3D,
- coller un substrat de manipulation sur ladite surface plane,
- retirer le substrat de croissance de façon à exposer la couche de masquage et une portion du cœur au travers de la couche de masquage.

Selon un exemple, le procédé comprend en outre :
- après le retrait du substrat de croissance, former le premier contact au contact de la portion exposée du cœur,
- suite à la formation du premier contact, déposer la couche magnétique sur une face inférieure de la couche de masquage.

La couche magnétique est ainsi disposée en face arrière de la diode, ce qui facilite son dépôt et sa structuration.

Selon un exemple, le procédé comprend en outre, entre la formation du premier contact et le dépôt de la couche magnétique, une formation d'une couche électriquement isolante de sorte que la couche électriquement isolante est intercalée entre le premier contact et la couche magnétique.

Selon un exemple, le procédé comprend en outre :
- former le deuxième contact sur la coquille, par exemple par dépôt d'une couche d'oxyde conducteurtransparent, et
- déposer la couche magnétique sur le deuxième contact, de préférence selon un plan d'extension principale sensiblement parallèle à la couche de masquage.

Ces étapes peuvent intervenir préalablement au dépôt de la couche de planarisation. Selon un exemple alternatif, lorsque la couche magnétique est déposée sur le deuxième contact, le procédé peut être exempt de dépôt d'une couche de planarisation.

La couche magnétique est ainsi disposée en face avant de la diode, autour des structures 3D. Selon cet exemple, le substrat de croissance peut être conservé, et sert de contact avec le cœur de type n. Le procédé de fabrication est ainsi réalisé en face avant du côté des structures 3D. La couche magnétique est déposée en face avant, sur le deuxième contact par exemple, ou séparée du deuxième contact par une couche isolante.

Selon un exemple, le procédé comprend en outre, entre la formation du deuxième contact et le dépôt de la couche magnétique, une formation d'une couche électriquement isolante de sorte que la couche électriquement isolante est intercalée entre le deuxième contact et la couche magnétique.

Selon un exemple, le substrat de manipulation est à base d'un matériau transparent à la longueur d'onde λ. Le substrat de manipulation peut ainsi être conservé à l'issue du procédé. Alternativement, le substrat de manipulation peut être retiré à l'issue du procédé, typiquement lorsque le substrat de manipulation est à base d'un matériau opaque tel que le silicium.

Selon un exemple, les formations du cœur et de la coquille, et la formation de la région active, sont effectuées par épitaxie en phase vapeur à précurseurs organométalliques (MOVPE).

Selon un exemple, la diode électroluminescente comprend une pluralité de structures 3D, et la formation des cœurs est telle que deux cœurs adjacents sont séparés entre eux par une distance de séparation sensiblement inférieure à 20 µm, de préférence sensiblement comprise entre 1 µm et 5 µm. Les cœurs des diodes sont ainsi répartis sur le substrat avec une densité surfacique élevée. Cela favorise une croissance radiale des parties surmontant chaque cœur, notamment des régions actives.

Sauf incompatibilité, des caractéristiques techniques décrites en détail pour un mode de réalisation donné peuvent être combinées aux caractéristiques techniques décrites dans le contexte d'autres modes de réalisation décrits à titre exemplaire et non limitatif, de manière à former un autre mode de réalisation qui n'est pas nécessairement illustré ou décrit. Un tel mode de réalisation n'est évidemment pas exclu de l'invention.

Dans la présente invention, le dispositif et le procédé se rapportent en particulier à une architecture et à la fabrication de diodes électroluminescentes (LED) à structure 3D. L'invention peut être mise en œuvre plus largement pour différents dispositifs optoélectroniques à structure 3D. L'invention peut donc être également mise en œuvre dans le cadre de dispositifs laser ou photovoltaïque.

Dans la présente demande de brevet, les termes « diode électroluminescente », « LED » ou simplement « diode » sont employés en synonymes. Une « LED » peut également s'entendre d'une « micro-LED ».

Sauf mention explicite, il est précisé que, dans le cadre de la présente invention, la disposition relative d'une troisième couche intercalée entre une première couche et une deuxième couche, ne signifie pas obligatoirement que les couches sont directement au contact les unes des autres, mais signifie que la troisième couche est soit directement au contact des première et deuxième couches, soit séparée de celles-ci par au moins une autre couche ou au moins un autre élément. Ainsi, les termes et locutions « prendre appui » et « couvrir » ou « recouvrir » ou encore « sur » ne signifient pas nécessairement « au contact de ». Typiquement, la coquille prend appui sur la région active soit directement, soit indirectement, par exemple par l'intermédiaire d'une couche de blocage d'électrons intercalée. La région active peut prendre appui sur le cœur soit directement, soit indirectement, par exemple par l'intermédiaire d'une barrière quantique intercalée.

Les LED selon la présente invention sont de préférence à base de matériaux III-V, notamment à base de GaN. Les différentes parties et régions de la LED présentent typiquement une structure cristallographique hexagonale. On notera, selon le système de Miller-Bravais, (hkil) un plan de la structure hexagonale, {hkil} une famille de plans de la structure hexagonale, [hkil] une direction ou un vecteur de la structure hexagonale.

L'efficacité quantique externe EQE peut être décomposée en trois composantes :
- l'efficacité d'injection (IE) des porteurs dans la région active,
- l'efficacité quantique interne (IQE) qui est le ratio entre le nombre de recombinaisons radiatives et le nombre de recombinaisons total,
- l'efficacité d'extraction lumineuse (LEE) qui correspond à la proportion de photons sortant de la LED par rapport au nombre de photons générés.

Le terme « structure 3D » s'entend par opposition aux structures dites planaires ou 2D, qui présentent deux dimensions dans un plan très supérieures à la troisième dimension normale au plan. Ainsi, les structures 3D usuelles visées dans le domaine des LED 3D peuvent se présenter sous forme de fil, de nanofil ou de microfil, ou encore de pyramide. Une telle structure 3D présente une forme allongée ou encore orientée selon la direction longitudinale z. La dimension longitudinale du fil, selon z sur les figures, est supérieure, et de préférence très supérieure, aux dimensions transverses du fil, dans le plan xy sur les figures. La dimension longitudinale, et notamment pour un fil, est par exemple sensiblement comprise entre au moins deux fois, et au moins dix fois, supérieure aux dimensions transverses, de préférence comprise entre trois fois et cinq fois les dimensions transverses. Dans l'exemple de pyramides, les rapports dimensions longitudinale sur dimensions transverses peuvent être fixes. Cela dépend typiquement des géométries des cristaux de GaN. Par exemple, pour une pyramide, le rapport de la dimension longitudinale sur une dimension transverse est sensiblement inférieur ou égal à 0,9.

Les structures 3D peuvent également se présenter sous forme de murs. Dans ce cas, seule une dimension transverse du mur est très inférieure aux autres dimensions, par exemple de trois fois à cinq fois, inférieure aux autres dimensions. Les structures 3D de la présente demande présentent de préférence des parois ou des flancs sensiblement verticaux ou oblique dans le cas de forme de pyramide. Les parois verticales s'étendent typiquement selon des plans cristallographiques de type m {10-10}. Elles peuvent être impliquées dans un mécanisme de croissance dite radiale. Les structures 3D de la présente demande, et notamment les structures en forme de fil, présentent de préférence des bases et des sommets comprenant des surfaces sensiblement horizontales. Ces surfaces horizontales s'étendent typiquement selon des plans cristallographiques de type c (0001) ou -c (000-1). Elles peuvent être impliquées dans un mécanisme de croissance dite axiale. Selon une possibilité, les structures 3D se présentent sous forme de pyramides ou de nanopyramides. Selon une autre possibilité, les structures 3D se présentent sous forme de pyramides « allongées » ou sous forme de « crayon », typiquement un nanofil surmonté par une pyramide.

On entend par « croissance axiale » une croissance anisotrope se produisant essentiellement voire uniquement selon la direction longitudinale z. On entend par « croissance radiale » une croissance isotrope couvrant notamment les surfaces parallèles à la direction longitudinale z. Les étapes du procédé telles que revendiquées s'entendent au sens large et peuvent éventuellement être réalisées en plusieurs sous-étapes.

On entend par un substrat, une couche, un dispositif, « à base » d'un matériau M, un substrat, une couche, un dispositif comprenant ce matériau M uniquement ou ce matériau M et éventuellement d'autres matériaux, par exemple des éléments d'alliage, des impuretés ou des éléments dopants.

Dans la suite, les abréviations suivantes relatives à un matériau M sont éventuellement utilisées :
- a-M réfère au matériau M sous forme amorphe, selon la terminologie habituellement utilisée dans le domaine de la microélectronique pour le préfixe a-.
- p-M réfère au matériau M sous forme polycristalline, selon la terminologie habituellement utilisée dans le domaine de la microélectronique pour le préfixe p-.

De même, les abréviations suivantes relatives à un matériau M sont éventuellement utilisées :
- M-i réfère au matériau M intrinsèque ou non intentionnellement dopé, selon la terminologie habituellement utilisée dans le domaine de la microélectronique pour le suffixe -i.
- M-n réfère au matériau M dopé N, N+ ou N++, selon la terminologie habituellement utilisée dans le domaine de la microélectronique pour le suffixe -n.
- M-p réfère au matériau M dopé P, P+ ou P++, selon la terminologie habituellement utilisée dans le domaine de la microélectronique pour le suffixe -p.

Un repère, de préférence orthonormé, comprenant les axes x, y, z est représenté sur les figures. L'axe z est ici parallèle à l'axe c, c'est-à-dire à la direction cristallographique [0001].

Dans la présente demande de brevet, on parlera préférentiellement d'épaisseur pour une couche et de hauteur pour une structure ou un dispositif. L'épaisseur est prise selon une direction normale au plan d'extension principal de la couche, et la hauteur est prise perpendiculairement au plan basal xy du substrat. Ainsi, une couche présente typiquement une épaisseur selon z, lorsqu'elle s'étend principalement le long d'un plan xy, et une LED présente une hauteur selon z. Les termes relatifs « sur », « surmonte », « sous », « sous-jacent » se réfèrent à des positions prises selon la direction z.

Les valeurs dimensionnelles s'entendent aux tolérances de fabrication et de mesure près. Les termes « sensiblement », « environ », « de l'ordre de » signifient, lorsqu'ils se rapportent à une valeur, « à 10% près » de cette valeur ou, lorsqu'ils se rapportent à une orientation angulaire, « à 10° près » de cette orientation. Ainsi, une direction sensiblement normale ou perpendiculaire à un plan signifie une direction présentant un angle de 90±10° par rapport au plan.

Pour déterminer la géométrie des structures 3D et les compositions des différents éléments (fil, région active, couche de ralentissement) de ces structures 3D, on peut procéder à des analyses de Microscopie Electronique à Balayage (MEB) ou de Microscopie Electronique en Transmission (MET ou TEM pour l'acronyme anglais de « Transmission Electron Microscopy ») ou encore ou de Microscopie Electronique en Transmission à Balayage STEM (acronyme anglais de « Scanning Transmission Electron Microscopy »).

Le TEM ou le STEM se prêtent notamment bien à l'observation et à l'identification des puits quantiques - dont l'épaisseur est généralement de l'ordre de quelques nanomètres - dans la région active. Différentes techniques listées ci-après de façon non exhaustive peuvent être mises en œuvre : l'imagerie en champ sombre (dark field) et en champ clair (bright field), en faisceau faible (weak beam), en diffraction aux grands angles HAADF (acronyme anglais de « High Angle Annular Dark Field »).

Les compositions chimiques des différents éléments peuvent être déterminées à l'aide de la méthode bien connue EDX ou X-EDS, acronyme de « energy dispersive x-ray spectroscopy » qui signifie « analyse dispersive en énergie de photons X ».

Cette méthode est bien adaptée pour analyser la composition de dispositifs optoélectroniques de petites tailles telles que des LED 3D. Elle peut être mise en œuvre sur des coupes métallurgiques au sein d'un Microscope Electronique à Balayage (MEB) ou sur des lames minces au sein d'un Microscope Electronique en Transmission (MET).

Les techniques mentionnées ci-dessus permettent notamment de déterminer si un dispositif optoélectronique à structure 3D comprend une couche magnétique au sens de la présente invention, et/ou une couche de masquage indicatrice d'une mise en œuvre d'une croissance localisée, tel que décrit dans la présente invention.

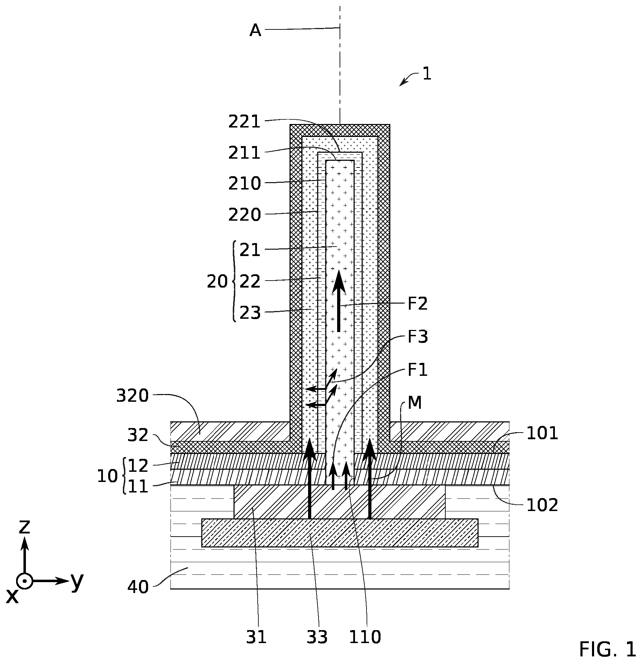

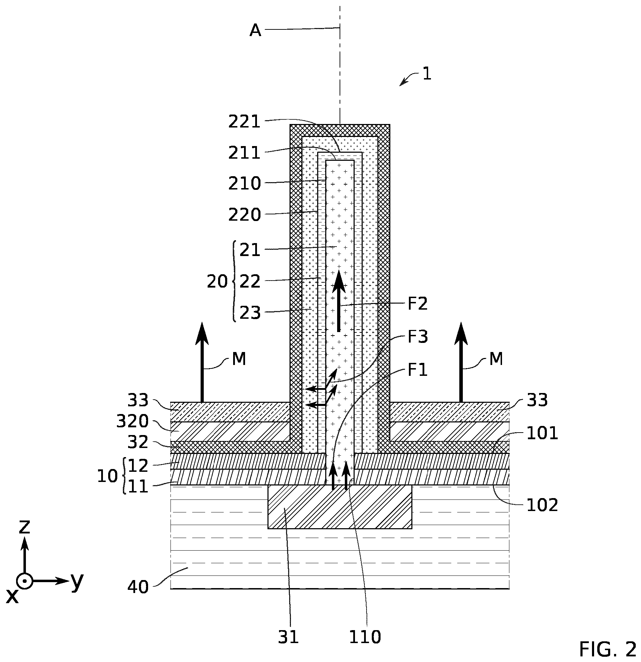

Les figures 1 et 2 illustrent une LED 1 comprenant une structure 3D 20 en forme de nanofil, selon deux exemples particuliers de réalisation de l'invention. La structure 3D 20 de la LED présente une architecture radiale également appelée cœur-coquille. Une telle architecture radiale peut notamment comprendre, de l'intérieur vers l'extérieur du nanofil selon la direction y :
- une première partie 21, ou de façon équivalente un cœur 21, ayant un diamètre compris entre 50 nm et 1,2 µm, typiquement de l'ordre de 700 nm. Cette première partie 21 forme le noyau ou le cœur du nanofil. Elle est de préférence constituée de GaN-n,
- une région active 22 d'épaisseur comprise entre 20 nm et 250 nm, typiquement de l'ordre de 40 nm. La région active 22 couvre les flancs 210 et le sommet 211 du cœur 21, respectivement par une partie radiale 220 et une partie sommitale 221. Elle est de préférence constituée d'InGaN. La région active 22 comprend de préférence des puits quantiques InGaN-i alternant avec des barrières quantiques GaN-i. Les puits quantiques peuvent avoir une épaisseur comprise entre 1 nm et 15 nm et les barrières quantiques peuvent avoir une épaisseur comprise entre 3 nm et 20 nm,
- de façon optionnelle uniquement, et non représentée sur les figures, une couche de blocage d'électrons (EBL) d'épaisseur comprise entre 10 nm et 100 nm, typiquement 30 nm. La couche EBL est de préférence constituée d'AlGaN. L'EBL couvre de préférence partie radiale 220 et la partie sommitale 221 de la région active 22,
- une deuxième partie 23, ou de façon équivalente une coquille 23, d'épaisseur comprise entre 50 nm et 500 nm, typiquement de l'ordre de 250 nm. La coquille 23 couvre la partie radiale 220 et la partie sommitale 221 de la région active 22. Elle est de préférence constituée de GaN-p. La coquille 23 peut couvrir directement la partie radiale 220 et la partie sommitale 221 de la région active 22, ou couvrir l'EBL lorsqu'une EBL est présente.

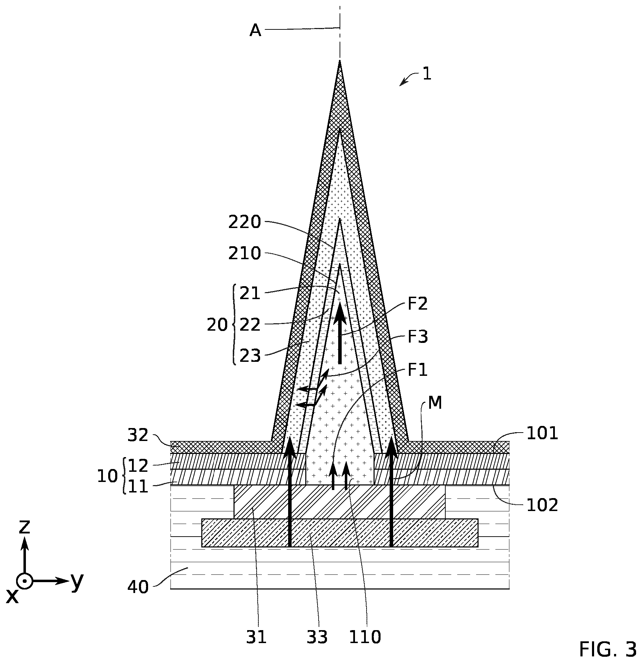

La figure 3 illustre une LED 1 comprenant une structure 3D 20 en forme de pyramide, selon un autre exemple particulier de réalisation de l'invention. Selon cet exemple, le cœur 21 présente une forme de pyramide dotée de flanc 210 obliques par rapport à la direction z. La région active 22 couvre les flancs 210 du cœur 21 par une partie radiale 220. La coquille 23 couvre la partie radiale 220 de la région active 22.

On considère dans la suite à titre non limitatif que la structure 3D 20 est en forme de nanofil. Les caractéristiques détaillées ci-après, sauf incompatibilité, peuvent tout à fait s'appliquer à une forme pyramidale de la structure 3D 20.

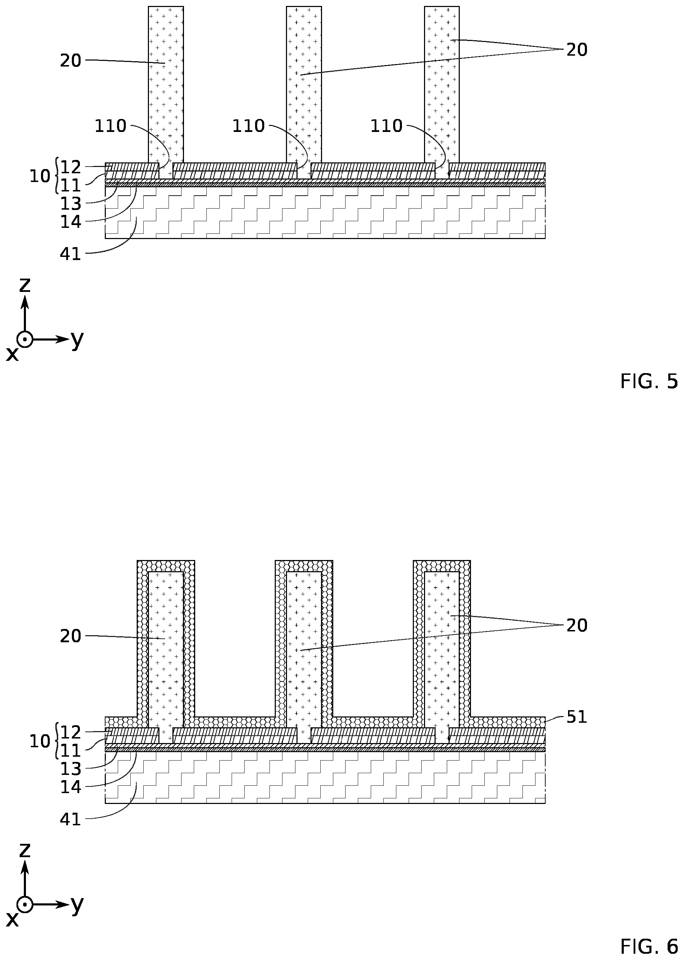

La LED comprend typiquement une couche de masquage 10 mise en œuvre lors du procédé de croissance du nanofil. Cette couche de masquage 10 peut comprendre plusieurs sous-couches, par exemple une couche 11 à base ou faite de nitrure de silicium et une couche 12 à base ou faite d'oxyde. La couche de masquage 10 comprend des ouvertures 110 configurées pour favoriser la croissance locale des nanofils, comme l'illustre également la figure 5. Lors de la croissance, le cœur 21 traverse typiquement la couche de masquage 10 au niveau d'une ouverture 110, puis s'étend essentiellement selon z. Selon une possibilité, la section dans le plan xy du cœur 21 augmente brusquement à la sortie de l'ouverture 110. Le cœur 21 peut ainsi prendre appui sur la face supérieure 101 de la couche de masquage 10.

La LED peut comprendre en outre un premier contact 31 électriquement conducteur, configuré pour injecter des porteurs de charge dans le cœur 21, comme illustré par les flèches F1 dans les figures 1 à 3. Dans l'exemple illustré, les porteurs de charge injectés par le premier contact 31 sont des électrons. Le premier contact 31 peut être métallique, par exemple à base d'aluminium. Avantageusement, ce premier contact 31 peut également être utilisé comme réflecteur optique, pour réfléchir la lumière émise par la région active 22 du côté du sommet du nanofil (c'est-à-dire du côté de la « face avant » du dispositif). Cela permet d'améliorer l'efficacité d'extraction lumineuse de la LED. Le premier contact 31 est typiquement isolé électriquement par une couche diélectrique 40, par exemple à base d'oxyde de silicium, située sur la face inférieure 102 de la couche de masquage 10 autour du premier contact 31.

La LED peut en outre comprendre un deuxième contact 32 électriquement conducteur, configuré pour injecter des porteurs de charge dans la coquille 23. Dans l'exemple illustré, les porteurs de charge injectés par le deuxième contact 32 sont des trous. Le deuxième contact 32 est typiquement transparent à la longueur d'onde de la lumière émise par la région active 22. Le deuxième contact 32 est par exemple à base d'oxyde conducteur transparent TCO (acronyme de « transparent conducting oxide »), par exemple à base d'ITO (acronyme de « indium tin oxide »). Selon un principe de la présente invention, la LED 3D comprend avantageusement une couche magnétique 33 configurée pour présenter une polarisation M, comme illustré dans les figures 1 à 3. Cette polarisation est orientée de façon sensiblement parallèle avec la direction z. Ainsi, on comprend que la polarisation M est orientée selon une direction principale non perpendiculaire, et par exemple sensiblement parallèle ou oblique (par oblique, on entend formant plus particulièrement un angle non nul et non droit, par exemple compris strictement entre 0° et 90°, 0° et 90° étant exclus) avec la partie radiale 220 de la région active 22. La polarisation M est donc orientée selon une direction formant plus particulièrement un angle non droit, par exemple compris entre 0° et 90°, 90° étant exclu) avec la partie radiale 220 de la région active 22. Le champ magnétique généré vient ainsi perturber la trajectoire des électrons. Les électrons se propagent selon la flèche F2 dans le cœur 21. Au niveau de la jonction p/n dans la partie radiale 220 de la région active 22, leur trajectoire est perturbée par le champ magnétique généré, comme l'illustrent les flèches F3 ce qui ralenti les électrons au niveau des flanc 210 du cœur 21 et de la partie radiale 220 de la région active 22. Leur temps de résidence étant augmenté, la recombinaison des paires électron-trou est favorisée au niveau d'un plan m, favorisant ainsi une recombinaison radiative.

La couche magnétique 33 présente de préférence une polarisation d'intensité comprise entre 0,1 T et 1,5 T, de préférence sensiblement égale à 0,5 T. La structure 3D 20 peut présenter une hauteur selon z comprise entre 100 nm à 5 µm. La structure 3D 20 peut présenter au moins une dimension dans le plan xy comprise entre 300 nm et 3 µm. Les gammes de polarisation décrites sont en effet avantageusement adaptées pour générer un champ magnétique impactant de façon satisfaisante la trajectoire des électrons lors de la propagation dans le cœur 21. La polarisation de la couche magnétique 33 peut être permanente. On peut prévoir que la polarisation dans la couche magnétique 33 soit induite par une source magnétique additionnelle.

Les électrons étant perturbés à distance par le champ magnétique, il est possible de disposer cette couche magnétique 33 à différents endroits par rapport à la structure 3D 20. Un contact électrique notamment entre la couche magnétique et les contacts électriques 31, 32 n'est pas nécessaire. C'est l'orientation relative de la couche magnétique 33, et donc de sa polarisation M, par rapport à la partie radiale 220 de la région active 22 qui participe principalement à cet effet plutôt que sa position relativement à la structure 3D. Deux exemples sont décrits ci-dessous à titre non-limitatif. D'autres configurations peuvent être envisagées.

Selon un premier exemple particulier, illustré en figures 1 et 3, la couche magnétique 33 est sous-jacente, selon la direction z, à la structure 3D 20, et notamment au premier contact 31. La couche magnétique 33 peut être directement en contact électrique avec le premier contact 31 ou par l'intermédiaire d'une couche distincte de ce premier contact 31, par exemple par l'intermédiaire d'une couche électriquement isolante 40 décrite ultérieurement.

Selon un deuxième exemple particulier alternatif ou combinable au précédent, et illustré en figure 2, la couche magnétique 33 surmonte la face supérieure, selon la direction z, de la couche de masquage 10. La couche magnétique 33 peut par exemple surmonter le deuxième contact 32. Ici encore la couche magnétique 33 peut être directement en contact électrique avec le deuxième contact 32 ou par l'intermédiaire d'une couche distincte de ce deuxième contact 32, par exemple par l'intermédiaire d'une couche électriquement isolante 61 décrite ultérieurement.

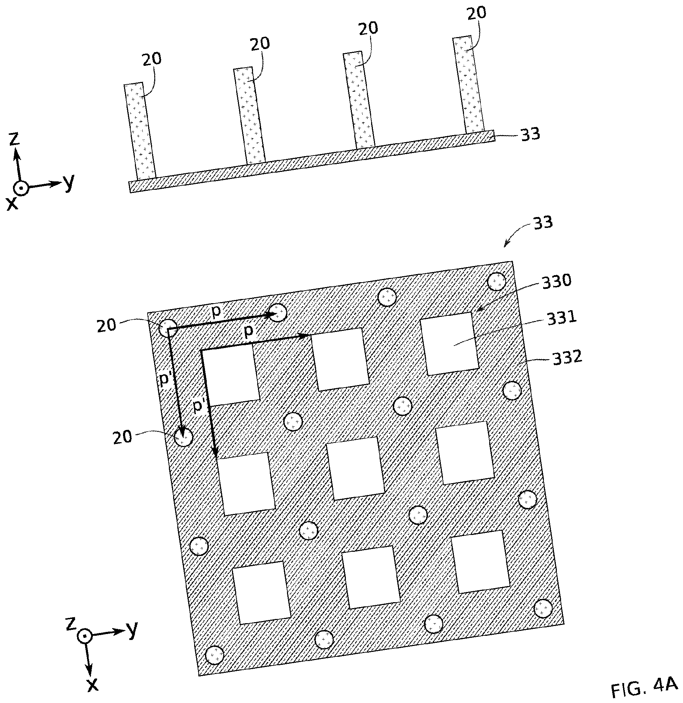

De préférence, la couche magnétique 33 est discontinue. Comme illustré par exemple par les figures 4A à 4C, la couche magnétique peut donc comprendre des portions 332 à base ou faite d'un matériau magnétique, et des portions 331 dépourvues de matériau magnétique (par exemple à base ou faites d'un matériau amagnétique, tel qu'un diélectrique). Ces discontinuités permettent une génération de maximums locaux de champ magnétique. Les portions 331 et 332 forment ensemble de préférence un motif se répétant à intervalle régulier dans une et de préférence deux directions du plan xy d'extension principale de la couche magnétique 33. Ces maximums locaux sont ainsi répartis de façon régulière dans la couche magnétique 33.

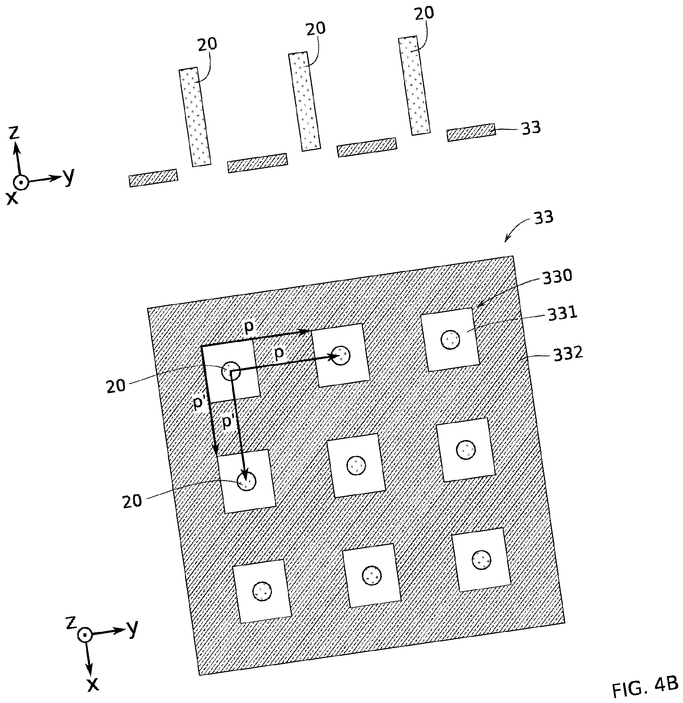

Comme l'illustrent les figures 4A et 4B par exemple, la couche magnétique 33 comprendre une portion 332 magnétique dans laquelle des cavités ou plots amagnétiques 331 sont réalisé(e)s.

Ces cavités ou plots forment des motifs 330 espacés selon un premier réseau par des pas p et p' respectivement dans les directions y et x. p et p' sont de préférence mais non nécessairement sensiblement égaux.

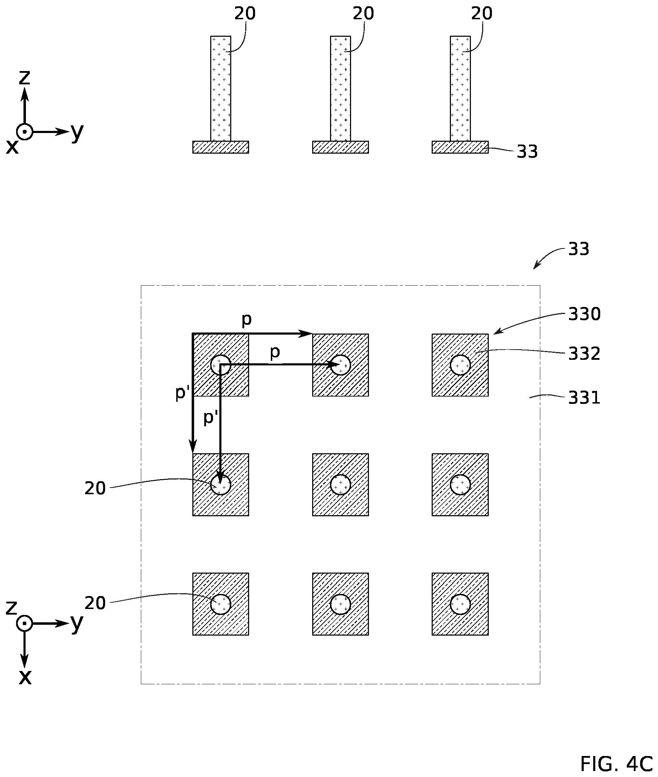

Comme l'illustre la figure 4C, les motifs 330 peuvent être formés de façon positive en matériau magnétique. Ainsi, des plots 332 de matériaux magnétiques peuvent être distribués dans le premier réseau selon les pas p et p'. Chaque plot 332 peut être entouré par une portion 331 dépourvue de matériau magnétique.

Notons que toute forme, par exemple circulaire ou polygonale, peut être envisagée pour les motifs 330. Les motifs 330 ne sont pas nécessairement distribués dans les deux directions x et y, bien que cela soit préféré. Les motifs 330 peuvent par exemple être des rainures espacées par un pas p selon la direction y.

De préférence, les structures 3D 20 sont disposées en coïncidence des motifs 330, de façon à placer les structures 3D 20 au niveau des maximums locaux de champ magnétique. Pour cela, les structures 3D 20 peuvent être distribuées dans un deuxième réseau selon les même pas p, p' que les motifs 330 de la couche magnétique 33. Notons qu'on peut placer chaque structure 3D dans une portion à base de matériau magnétique 332 ou dans une portion dépourvue de matériau magnétique 331, comme l'illustrent respectivement les figures 4A, 4C et la figure 4B.

Les figures 5 à 18B illustrent différentes étapes d'un procédé de réalisation d'une LED à structure 3D 20 comprenant une couche magnétique 33 telle que décrite précédemment, selon plusieurs exemples de réalisation particuliers.

Dans la suite, les structures 3D 20 se présentent à titre non limitatif sous forme de nanofils. L'architecture interne de ces structures 3D 20 radiale n'est pas détaillée relativement au procédé de fabrication. L'homme du métier sait adapter le procédé pour l'obtention de structures 3D pyramidales.

Comme illustré à la figure 5, les nanofils 20 sont d'abord formés sur un substrat de croissance 41. Le substrat 41 peut être à base de silicium et faire office de support. Le substrat 41 porte typiquement une ou plusieurs couches 13, 14 à base ou faite de matériaux III-V ou de nitrures de métaux, et notamment de nitrures de métaux réfractaires. Selon des exemples alternatifs, ces couches 13 et 14 peuvent être continues (comme illustré) ou gravées et donc discontinues (non illustré sur les figures). Une couche 13 superficielle, appelée couche de nucléation, permet de faire croître les nanofils 20. La couche de nucléation 13 est de préférence à base d'AIN. Elle peut être alternativement à base d'autres nitrures métalliques, par exemple GaN ou AlGaN. Elle peut être formée sur le support 41 en silicium par épitaxie, de préférence par épitaxie en phase vapeur à précurseurs organométalliques MOVPE (acronyme de « MetalOrganic Vapour Phase Epitaxy »). Elle présente avantageusement une épaisseur inférieure ou égale à 200 nm, de préférence inférieure ou égale à 100 nm, par exemple de l'ordre de 50 nm.

Une couche de masquage 10 est de préférence formée sur la couche de nucléation 13. Elle peut comprendre plusieurs sous-couches à base de matériau diélectrique, par exemple en nitrure de silicium Si₃N₄ et/ou en oxyde de silicium. La couche de masquage 10 peut être formée par dépôt chimique en phase vapeur CVD (acronyme de « Chemical Vapor Deposition »). Elle masque en partie la couche de nucléation 13 et comprend des ouvertures 110 de préférence circulaires exposant des zones de la couche de nucléation 13. Ces ouvertures 110 présentent typiquement au moins une dimension, par exemple un diamètre, comprise entre 30 nm et 500 nm. Les ouvertures 110 peuvent être distribuées de façon régulière au sein de la couche de masquage 10, par exemple sous forme d'un réseau ordonné.

Une telle couche de masquage 10 permet une croissance localisée d'une structure 3D 20 au niveau de chaque ouverture 110. En particulier, lors d'une étape de croissance préliminaire appelée germination, un germe à base de GaN se forme au niveau de l'ouverture 110 puis remplit l'ouverture 110. La croissance ultérieure du nanofil 20 se fait alors à partir de ce germe, de façon localisée.

Lors de la formation des nanofils 20, les cœur 21, les régions actives 22 et les coquilles 23, sont successivement formées par épitaxie, de préférence par épitaxie en phase vapeur à précurseurs organométalliques MOVPE. Les nanofils 20 présentent typiquement un diamètre ou une dimension caractéristique dans le plan xy compris entre 200 nm et 2 µm. Les nanofils 20 présentent de préférence un sommet sensiblement horizontal, formé par un plan polaire c (0001) ou -c(000-1). Ils présentent des flancs sensiblement verticaux, formés par des plans non polaires m {10-10}.

Comme illustré à la figure 6, après formation des nanofils 20 par croissance localisée au travers de la couche de masquage 10, une couche diélectrique 51 est déposée de façon conforme sur les nanofils 20 et sur les parties exposées de la couche de masquage 10. La couche diélectrique 51 est par exemple à base d'oxyde de silicium SiO₂. Elle peut être formée par dépôt chimique en phase vapeur assisté par plasma PECVD (acronyme de « Plasma Enhanced Chemical Vapor Deposition »).

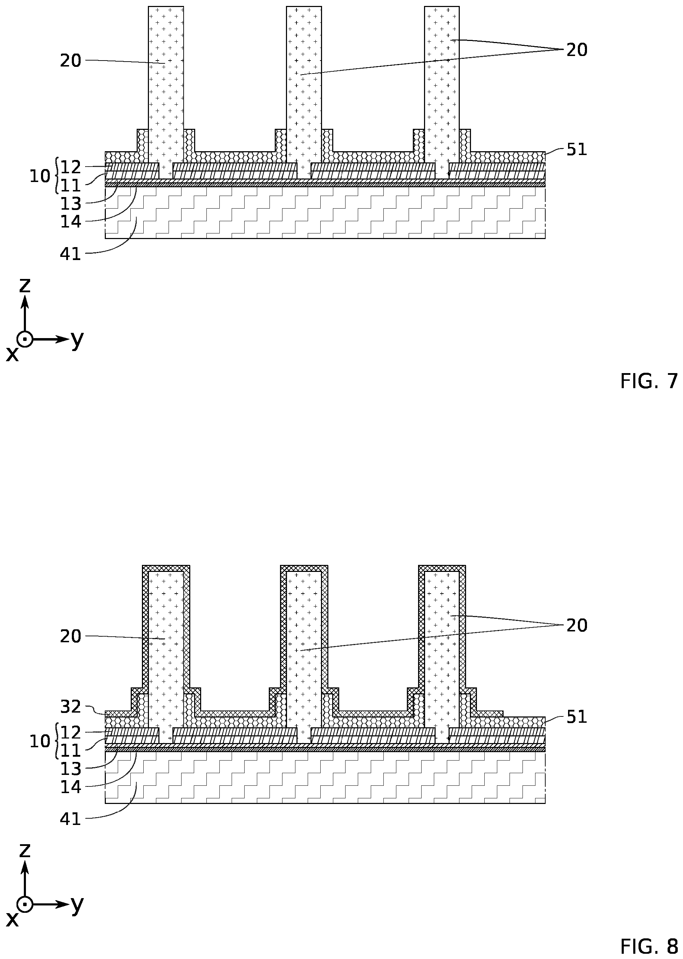

Comme illustré à la figure 7, la couche diélectrique 51 est ensuite gravée en partie, de façon à exposer les sommets et les flancs des nanofils 20 sur la quasi-totalité de leur hauteur. La gravure correspond typiquement à une gravure humide isotrope. A l'issue de la gravure, la couche diélectrique 51 est conservée sur la couche de masquage 10. Elle forme de préférence une bague à la base des nanofils 20. Elle permet de renforcer l'isolation électrique assurée en partie par la couche de masquage 10.

Comme illustré à la figure 8, une couche à base d'un matériau conducteur électrique transparent est déposée de façon continue sur et entre les nanofils 20. Cette couche continue recouvre ici totalement les sommets et les flancs exposés des nanofils 20. Elle permet de former le deuxième contact électrique 32. Elle est typiquement à base d'un oxyde conducteur transparent, par exemple à base d'ITO ou de ZnO. Un recuit à haute température peut être effectué de façon à obtenir un contact ohmique entre le deuxième contact électrique 32 et la coquille 23 de chaque nanofil 20.

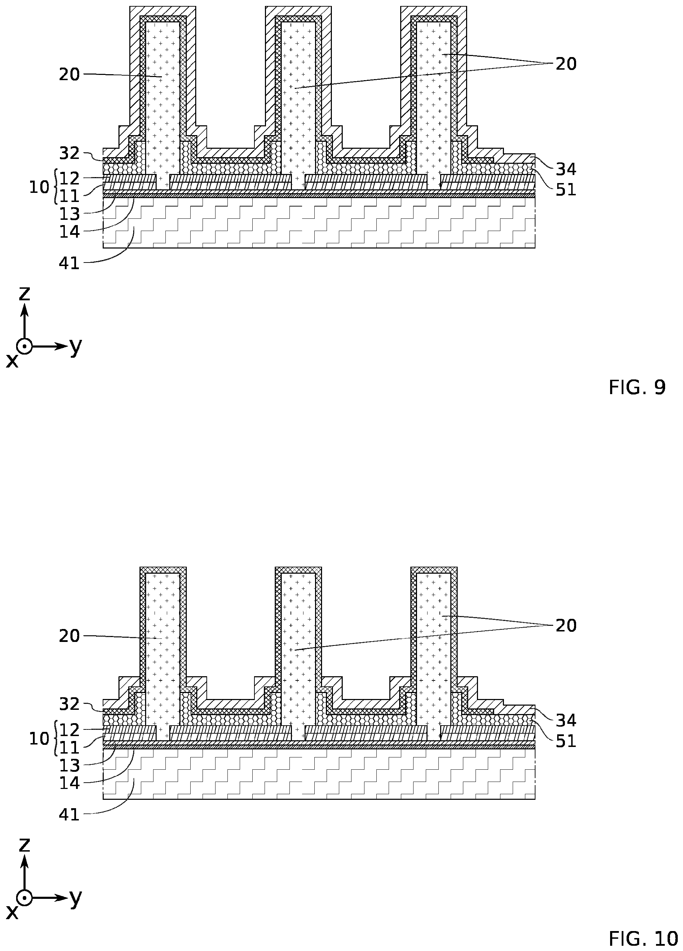

Comme illustré à la figure 9, une couche de métal 34 est ensuite déposée sur la couche continue formant le deuxième contact électrique 32. Cette couche de métal 34 est de préférence à base d'un métal réflecteur aux longueurs d'onde de la lumière émise par la région active 22. Elle est typiquement à base d'aluminium.

Comme illustré à la figure 10, la couche de métal 34 est ensuite gravée en partie, de façon à exposer la couche 32 continue sous-jacente sur la quasi-totalité de la hauteur des nanofils 20. La gravure correspond typiquement à une gravure isotrope. A l'issue de la gravure, la couche de métal 34 est conservée sur le deuxième contact électrique 32 entre les nanofils 20. Elle peut former une bague à la base des nanofils 20. Elle permet de former une nappe d'alimentation électrique pour le deuxième contact électrique 32. Elle permet en outre de former un réflecteur pour la lumière émise par la région active 22. L'efficacité d'extraction lumineuse de la LED est améliorée.

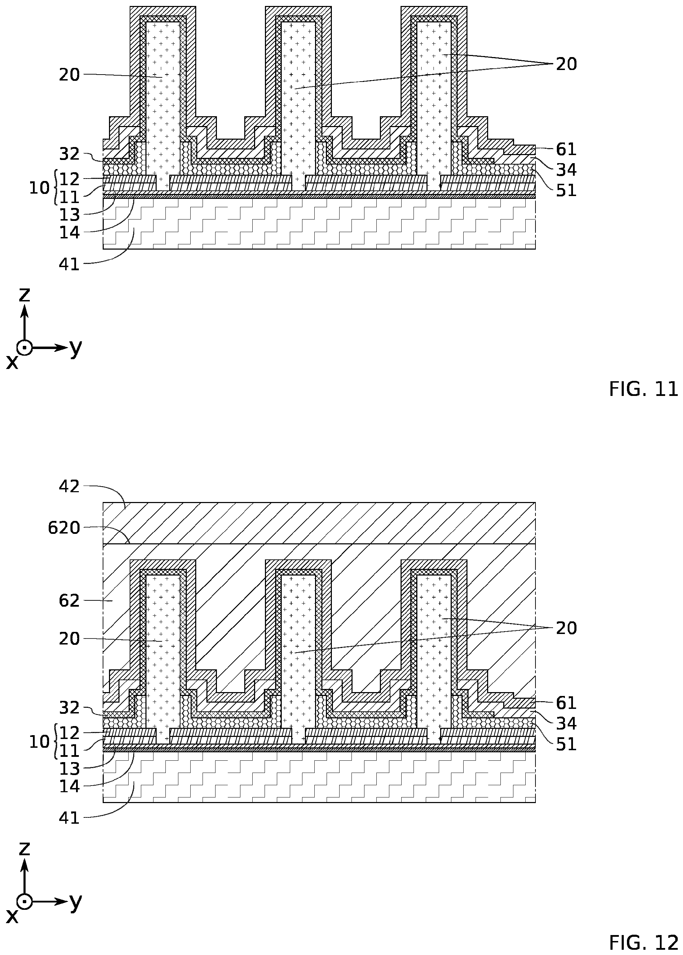

Comme illustré à la figure 11, une couche de passivation 61 peut ensuite être déposée sur les parties exposées du deuxième contact électrique 32 et sur la couche de métal 34. Cette couche de passivation 61 est par exemple à base de d'un alliage d'aluminium, par exemple à base d'Al₂O₃. Elle peut être en un matériau diélectrique. Elle peut être formée par dépôt chimique en phase vapeur assisté par plasma PECVD.

Comme illustré à la figure 12, les nanofils 20 en saillie du substrat 41 sont ensuite planarisés par une couche de planarisation 62. Cette couche de planarisation 62 est typiquement déposée entre et sur les nanofils 20, puis polie par polissage mécano-chimique (CMP) afin d'obtenir une surface plane 620 au-dessus des nanofils 20. Cette couche de planarisation 62 est typiquement isolante électriquement et transparente.

Un substrat de manipulation 42, également appelé « poignée », est ensuite collé par adhésion moléculaire sur la surface plane 620, en « face avant ». Ce substrat de manipulation 42 peut être transparent, par exemple à base de verre. Dans ce cas il peut être conservé dans le dispositif final, à l'issue du procédé de fabrication. Alternativement, le substrat de manipulation 42 est opaque, par exemple à base de silicium. Dans ce cas il est typiquement retiré en fin de procédé de fabrication, après réalisation des étapes dédiées à la « face arrière » ou face inférieure de la diode, selon la direction z.

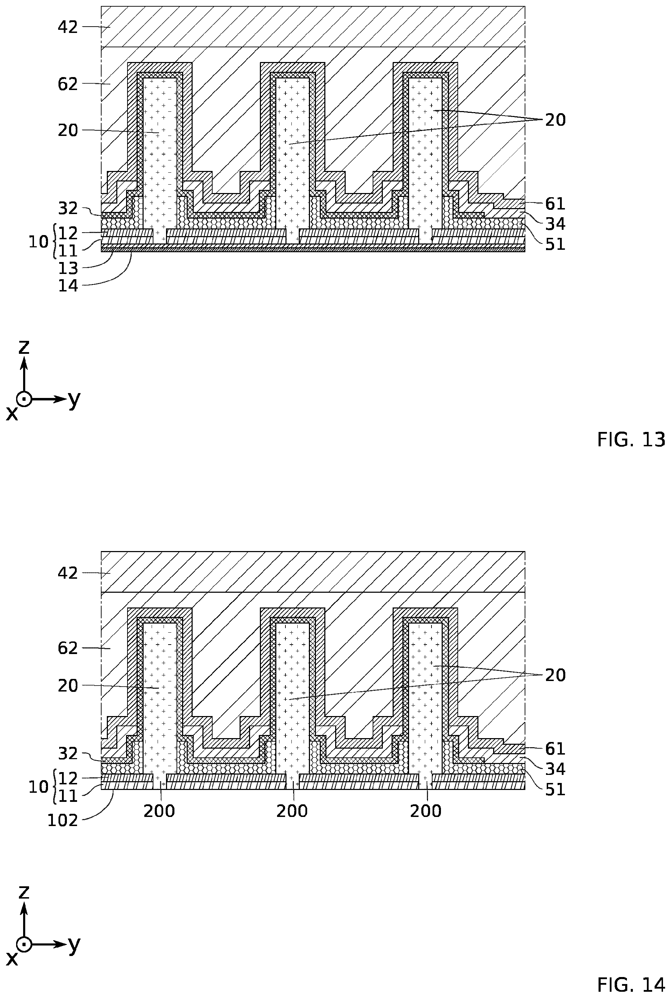

Comme illustré à la figure 13, après collage du substrat de manipulation 42, le substrat de croissance 41 peut être retiré. Ce retrait peut se faire de façon connue par une étape de rodage mécanique suivie d'une étape de gravure sèche ou de gravure humide.

Comme illustré à la figure 14, les couches 13, 14 à base de matériaux III-V ou de nitrures métalliques, utilisées précédemment pour la germination/nucléation des nanofils 20, sont ensuite retirées à partir de la face arrière, typiquement par une ou plusieurs gravures sèches. A l'issue du retrait des couches 13, 14, la face inférieure 102 de la couche de masquage 10 est exposée. Les portions 200 de nanofils 20 enserrées par la couche de masquage 10, correspondant initialement aux germes formés lors des étapes de germination/nucléation, sont également exposées à l'issue du retrait des couches 13, 14.

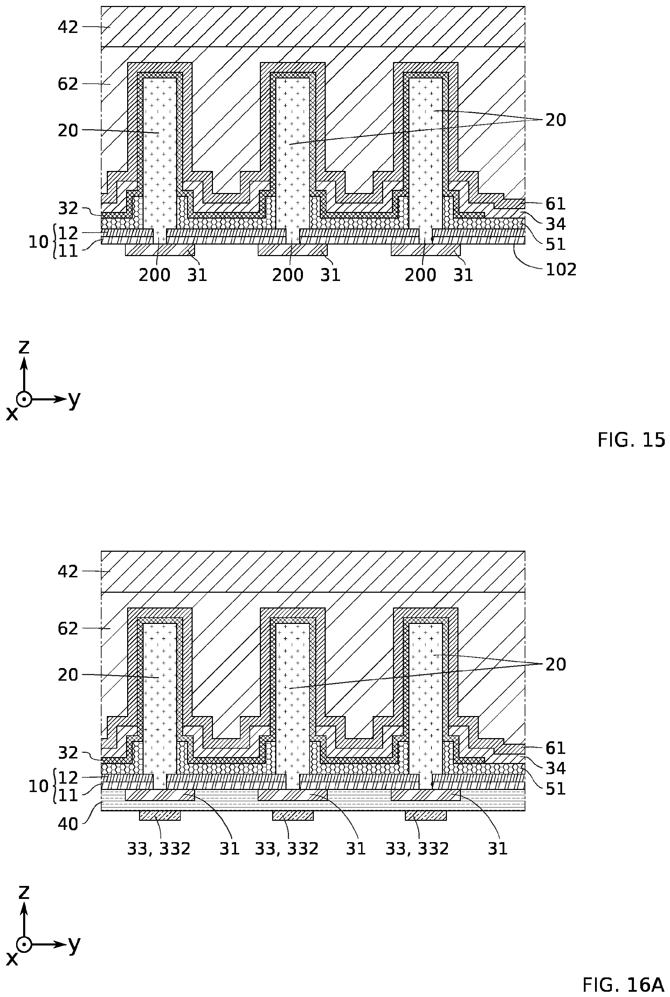

Comme illustré à la figure 15, selon une possibilité, les premiers contacts électriques 31 sont formés directement sur les portions 200 de nanofils 20. Ils recouvrent de préférence toutes les surfaces libres des portions 200 et prennent appui sur la face inférieure 102 de la couche de masquage 10. Les premiers contacts électriques 31 sont de préférence métalliques, typiquement à base d'aluminium. Ils assurent indirectement l'alimentation électrique des nanofils 20. Les premiers contacts électriques 31 forment également des réflecteurs en face arrière ou inférieure, afin de rediriger la lumière émise par les nanofils vers la face avant ou supérieure de la diode. Comme illustré à la figure 16A, une couche électriquement isolante 40, par exemple en matériau diélectrique peut, selon un premier exemple, être déposée en face arrière sur la face inférieure 102 et sur les premiers contacts électriques 31. Cette couche est ci-après désignée couche diélectrique 40. La couche diélectrique 40 peut être planarisée, par exemple par polissage chimique et/ou mécanique, pour assurer la qualité de la couche magnétique 33 qui sera ensuite déposée.

La couche magnétique 33 peut être déposée en face arrière ou inférieure, de façon à être sous-jacente à la couche diélectrique 40. Quel que soit l'exemple de réalisation, le dépôt de la couche magnétique 33 peut se faire avantageusement par différentes techniques classiques de dépôt physiques ou chimiques en phase vapeur, par exemple par pulvérisation magnétron, par exemple par dépôt par laser pulsé (abrégé PLD, de l'anglais Pulse Laser Deposition) ou par évaporation sous vide (évaporation thermique ou évaporation assistée par faisceaux d'électrons, par exemple).

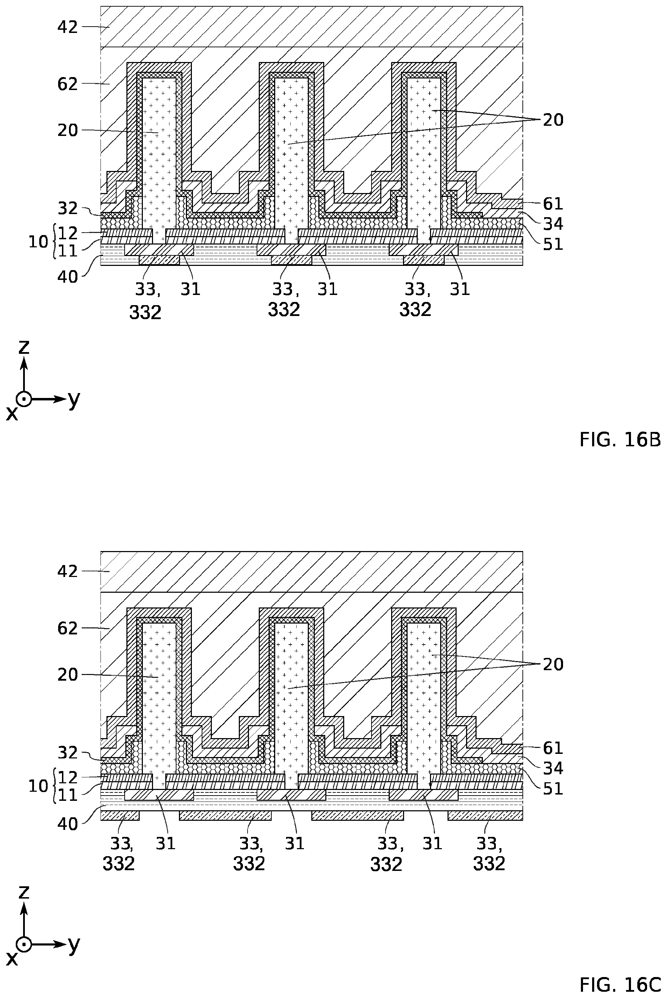

Suite au dépôt de la couche diélectrique 40, et quel que soit l'exemple de réalisation, le procédé peut comprendre une structuration de la couche magnétique 33, par exemple par photolithographie et/ou par gravure de façon à former les motifs 330 précédemment décrits. Comme illustré en variante à la figure 16B, la couche magnétique 33 peut être déposée directement sur les premiers contacts électriques 31, préalablement au dépôt de la couche diélectrique 40.

Les figures 16A et 16B illustrent un exemple de réalisation dans lequel les portions 332 à base ou faites d'un matériau magnétique sont alignées avec chaque structure 3D 20 selon la direction z. En variante, et comme illustré en figure 16C, les portions 332 à base ou faites d'un matériau magnétique peuvent être situées entre les nanofils 20, en projection dans un plan xy.

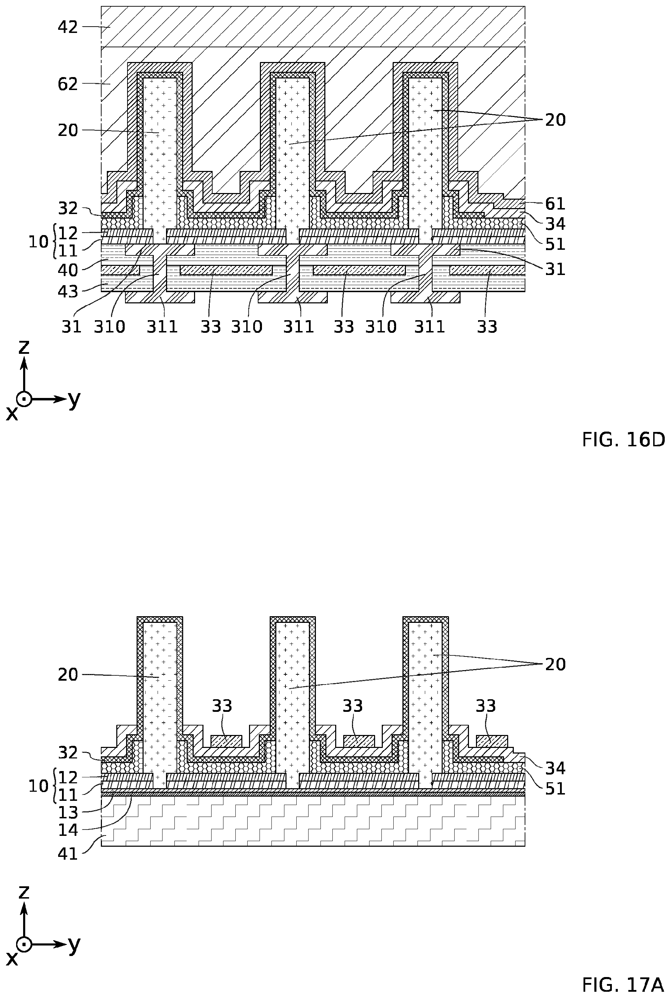

Comme illustré à la figure 16D, selon une possibilité, une couche diélectrique 43 est déposée en face arrière de façon à recouvrir la couche magnétique 33. Des vias 310 peuvent être formés au sein de la couche diélectrique 43, à l'aplomb des premiers contact électriques 31. Les premiers contacts électriques secondaires 311 sont alors formés sous forme de plots, sur la couche diélectrique 43, au contact des vias 310 préalablement remplis. Le remplissage des vias 310 et la formation des premiers contacts électriques secondaires 311 peut se faire simultanément en une seule étape.

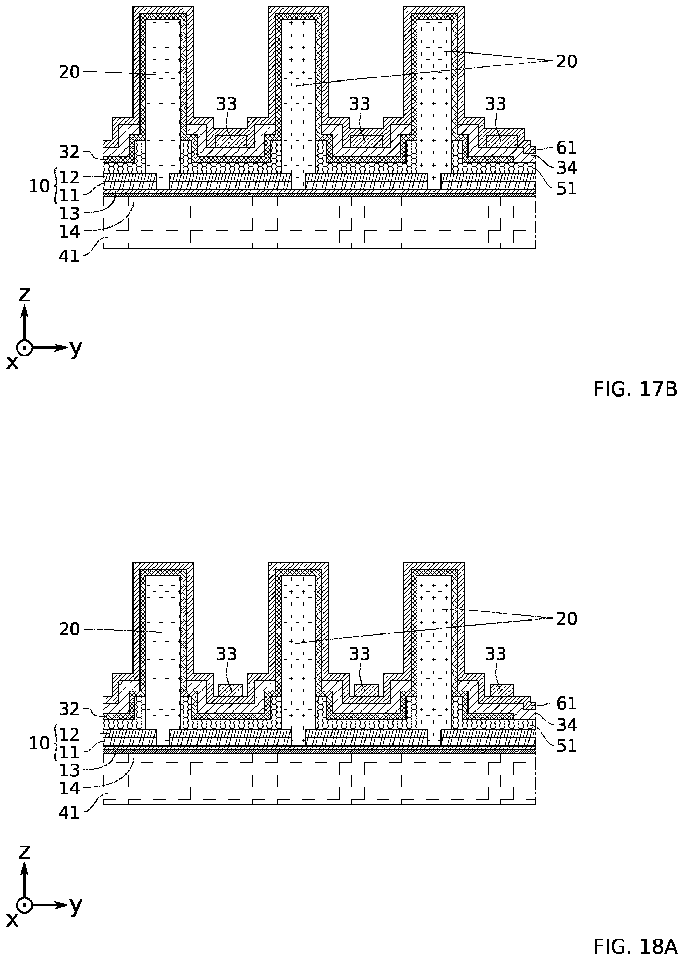

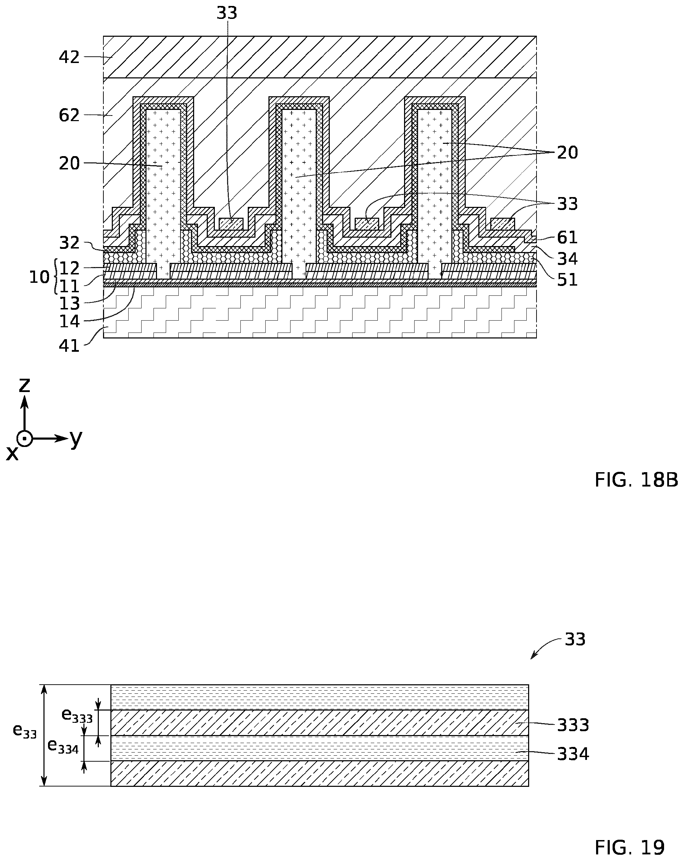

Selon une variante alternative ou combinable avec la réalisation de la couche magnétique 33 telle que précédemment décrite, la couche magnétique 33 peut être déposée en face avant entre les nanofils 20. Pour cela, suite à l'étape décrite relativement à la figure 10 par exemple, et comme illustré aux figures 17A et 17B, la couche magnétique 33 peut être déposée sur la couche de métal 34. La couche de passivation 61 peut ensuite être déposée. Ici encore, on peut prévoir que la couche magnétique 33 soit directement au contact de la couche de métal 34, ou par l'intermédiaire de la couche de passivation 61 lorsque cette couche de passivation 61 est déposée préalablement à la couche magnétique 33 en face avant (voir figure 18A). Le dépôt de la couche de planarisation 62 et les étapes subséquentes en face avant peuvent ensuite être réalisées comme précédemment décrit et comme l'illustre la figure 18B.

Après formation des premiers contacts électriques 31, la LED à base de nanofils 20 peut être connectée en face arrière, soit directement à une alimentation électrique, soit à une électronique de pilotage de la LED, par exemple basée sur la technologie de transistors complémentaires CMOS (acronyme de « Complementary Metal-Oxide-Semiconductor »). Le substrat de manipulation 42 peut être retiré, le cas échéant.

La couche magnétique 33 est désormais décrite plus en détail. La couche magnétique 33 peut être à base ou faite d'un matériau ferromagnétique, par exemple d'un matériau ferromagnétique comprenant au moins l'un parmi Co, Fe et Ni, tels que CoFeB, CoFe, NiW, NiFe. La couche magnétique 33 peut être formée d'une seule monocouche magnétique. Comme l'illustre par exemple la figure 19, la couche magnétique 33 peut comprendre un empilement de sous couches 333, 334. Cet empilement peut présenter une structure de type Metal/Ferromagnétique/Metal, dans laquelle une sous-couche ferromagnétique 333 est intercalée entre deux sous-couches 334 métalliques et amagnétique. Les sous-couches métalliques et amagnétiques 334 peuvent être à base ou faite d'au moins un parmi Pt, Pd, Ru, Cr, Ta. Les sous couches 334, 334 peuvent présenter des épaisseurs e₃₃₃, e₃₃₄ de l'ordre de quelques nanomètres.

La couche magnétique présente de préférence une épaisseur totale e₃₃ allant d'une à plusieurs dizaines de nanomètres, par exemple comprise entre 0,5 nm et 50 nm, de préférence entre 10 et 30 nm afin de générer un champ magnétique suffisant en relation avec la hauteur de la structure 3D 20.

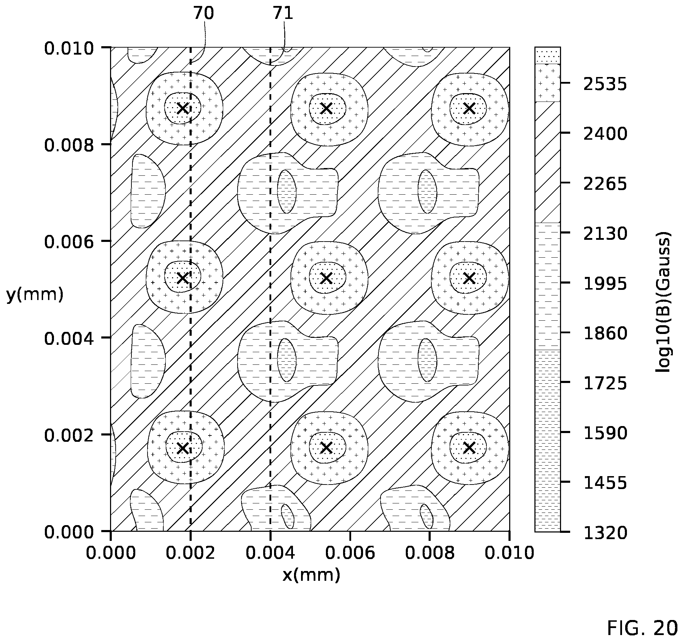

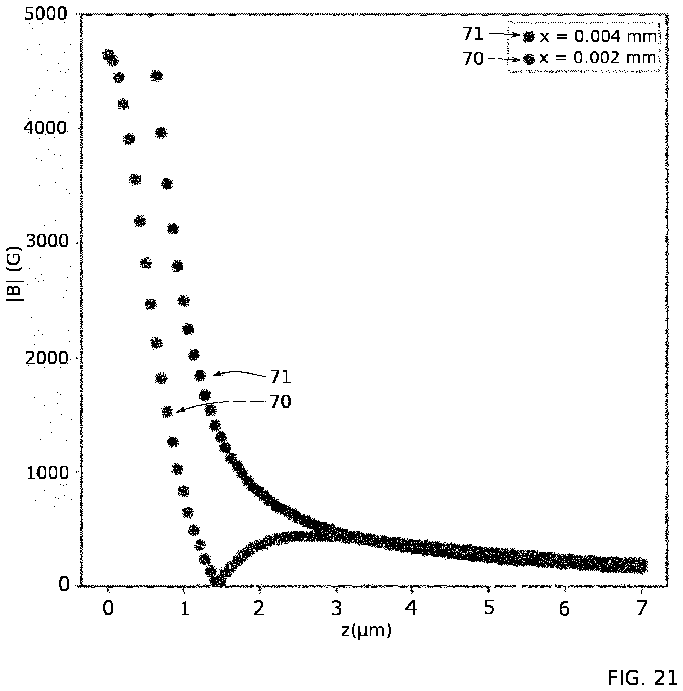

Les figures 20 et 21 illustrent une simulation de champ magnétique pouvant être obtenu pour un agencement de nanofils tel qu'illustré en figure 4A, avec une polarisation de 0,5T. En figure 20, les emplacements des nanofils sont marqués d'une croix noire. La figure 20 illustre le champ magnétique obtenu à la surface de la couche magnétique 33, montrant les maximums locaux de champs magnétique B obtenus par la structuration en motif de la couche magnétique 33. La figure 21 montre l'évolution selon la direction z du champ magnétique B dans l'axe des nanofils avec une polarisation de 0,5 T, selon les plans de coupe 70 et 71. Un champ magnétique suffisant peut être généré dans une partie importante d'une LED nanofil de 5 µm de haut, à partir d'une magnétisation de 0,5 T de la couche magnétique 33 située à la base du fil.

Il ressort de la description qui précède que la LED 3D selon l'invention est plus efficace qu'une LED 3D classique.

L'invention n'est pas limitée aux modes de réalisations précédemment décrits et s'étend à tous les modes de réalisation couverts par l'invention. La présente invention ne se limite pas aux exemples précédemment décrits. Bien d'autres variantes de réalisation sont possibles, par exemple par combinaison de caractéristiques précédemment décrites, sans sortir du cadre de l'invention. En outre, les caractéristiques décrites relativement à un aspect de l'invention peuvent être combinées à un autre aspect de l'invention. Sauf incompatibilité, des caractéristiques techniques décrites en détail pour un mode de réalisation donné peuvent être combinées aux caractéristiques techniques décrites dans le contexte d'autres modes de réalisation décrits à titre exemplaire et non limitatif, de manière à former un autre mode de réalisation qui n'est pas nécessairement illustré ou décrit. Un tel mode de réalisation n'est évidemment pas exclu de l'invention.

## Revendications

1. Diode électroluminescente (1) comprenant au moins une structure tridimensionnelle 3D (20) radiale comprenant :
- un cœur (21) présentant une première conductivité d'un premier type de porteurs, le cœur (21) présentant une forme de fil ou de pyramide orientés selon une direction z, et présentant des flancs (210) sensiblement parallèles ou obliques à la direction z,
- une région active (22) configurée pour émettre un rayonnement lumineux de longueur d'onde λ, la région active (22) comprenant au moins une partie dite radiale (220) couvrant les flancs (210) du cœur (21),
- une coquille (23) présentant une deuxième conductivité d'un deuxième type de porteurs, la coquille (23) couvrant au moins la partie radiale (220) de la région active (22),
la diode électroluminescente (1) étant **caractérisée en ce qu'**elle comprend au moins une couche magnétique (33) configurée pour présenter une polarisation (M) selon une direction principale sensiblement parallèle à la direction z, de façon à augmenter le temps de résidence au niveau de la région active (22) d'au moins l'un parmi le premier type et le deuxième type de porteurs.

2. Diode (1) selon la revendication précédente, dans laquelle les porteurs du premier type sont des électrons et la première conductivité est de type N, les porteurs du deuxième type sont des trous et la deuxième conductivité est de type P, l'au moins une couche magnétique (33) étant configurée de façon à augmenter le temps de résidence au niveau de la région active (22) des électrons s'étant propagés dans le cœur (21).

3. Diode (1) selon l'une quelconque des revendications précédentes, dans laquelle l'au moins une couche magnétique (33) s'étend dans un plan d'extension principale sensiblement perpendiculaire à la direction z et comprend des motifs (330) distribués selon un pas p le long d'au moins une direction de son plan d'extension principale, de façon à former une pluralité de portions (331) dépourvues de matériau magnétique, et de préférence lesdits motifs (330) sont distribués selon un premier réseau de pas p, le long de deux directions distinctes de son plan d'extension principale, de préférence la diode (1) comprend une pluralité de structures 3D (20), la pluralité de structures 3D (20) étant distribuées selon le même pas p que les motifs (330) de l'au moins une couche magnétique (33).

4. Diode (1) selon l'une quelconque des revendications précédentes, dans laquelle l'au moins une couche magnétique (33) présente une polarisation, de préférence permanente, comprise entre 0,1 T et 1,5 T.

5. Diode (1) selon l'une quelconque des revendications précédentes, dans laquelle l'au moins une couche magnétique (33) est à base d'un matériau ferromagnétique.

6. Diode (1) selon l'une quelconque des revendications précédentes, dans laquelle l'au moins une couche magnétique (33) comprend un empilement de sous-couches, ledit empilement comprenant au moins une première sous-couche (333) à base ou faite d'un matériau ferromagnétique, disposée entre deux deuxièmes sous-couches (334) à base d'un matériau métallique amagnétique.

7. Diode (1) selon l'une quelconque des revendications précédentes, dans laquelle l'au moins une couche magnétique (33) présente une épaisseur (e₃₃) comprise entre 0,5 nm et 50 nm, de préférence entre 10 nm et 30 nm.

8. Diode (1) selon l'une quelconque des revendications précédentes, dans laquelle :
• les flancs (210) du cœur (21) sont sensiblement parallèles à la direction z, et
• la partie radiale (220) de la région active (22) s'étend selon une direction d'extension principale sensiblement parallèle à la direction z.

9. Diode (1) selon l'une quelconque des revendications précédentes, la diode comprenant en outre :
• un premier contact (31) électriquement conducteur configuré pour injecter des porteurs du premier type dans le cœur (21),
• un deuxième contact (32) électriquement conducteur configuré pour injecter des porteurs du deuxième type dans la coquille (23).

10. Diode (1) selon la revendication précédente, dans laquelle l'au moins une couche magnétique (33) est sous-jacente, selon la direction z, au premier contact (31), de préférence la diode (1) comprend en outre au moins une couche électriquement isolante (40) intercalée entre l'au moins une couche magnétique (33) et le premier contact (31).

11. Diode (1) selon l'une quelconque des revendications précédentes, comprenant en outre une couche de masquage (10) présentant une face (102) dite inférieure, une face (101) dite supérieure, et des ouvertures (110), et dans laquelle le cœur (21) traverse la couche de masquage (10) au niveau desdites ouvertures (110), de préférence l'au moins une couche magnétique (33) surmonte, selon la direction z, la couche de masquage (10).

12. Procédé de réalisation d'une diode électroluminescente (1) comprenant au moins une structure tridimensionnelle 3D (20) selon l'une quelconque des revendications précédentes, le procédé comprenant :
• former le cœur (21) par épitaxie sur un substrat de croissance (41), par croissance localisée au travers d'une ouverture (110) d'une couche de masquage (10) disposée sur ledit substrat de croissance (41),
• former par épitaxie la région active (22) sur le cœur (21),
• former par épitaxie la coquille (23) sur la région active (22), puis
• déposer l'au moins une couche magnétique (33) de sorte que ladite couche magnétique (33) présente une polarisation (M) selon une direction principale sensiblement parallèle à la direction z.

13. Procédé selon la revendication précédente, comprenant en outre :
• déposer une couche de planarisation (62) sur le substrat de croissance (41), sur et autour de l'au moins une structure 3D (20) en saillie du substrat de croissance (41), de façon à obtenir une surface plane (620) au-dessus de l'au moins une structure 3D (20),
• coller un substrat de manipulation (42) sur ladite surface plane (620),
• retirer le substrat de croissance (41) de façon à exposer la couche de masquage (10) et une portion (200) du cœur (21) au travers de la couche de masquage (10).

14. Procédé selon la revendication précédente, comprenant en outre :
• après le retrait du substrat de croissance (41), former le premier contact (31) au contact de la portion (200) exposée du cœur (21),
• suite à la formation du premier contact (31), déposer la couche magnétique (33) sur une face inférieure (102) de la couche de masquage (10).

15. Procédé selon l'une quelconque des trois revendications précédentes, comprenant en outre :
• former le deuxième contact (32) sur la coquille (23), par dépôt d'une couche d'oxyde conducteurtransparent, et
• déposer la couche magnétique (33) sur le deuxième contact (32), selon un plan d'extension principale sensiblement parallèle à la couche de masquage (10).
